## Europäisches Patentamt

## European Patent Office

## Office européen des brevets

(19)

(11) Veröffentlichungsnummer: **0 180 804**
**B1**

(12) **EUROPÄISCHE PATENTSCHRIFT**

(45) Veröffentlichungstag der Patentschrift:
**01.06.88**

(51) Int. Cl.⁴: **C 25 D 5/10, C 25 D 5/50,**
**H 05 K 3/34, H 05 K 3/24**

(21) Anmeldenummer: **85112843.9**

(22) Anmeldetag: **10.10.85**

(54) Verfahren zur Erhaltung der Lötbarkeit von Bleizinn-Überzügen; sowie durchkontaktierte Leiterplatte.

(30) Priorität: **07.11.84 DE 3440668**

(43) Veröffentlichungstag der Anmeldung:
**14.05.86 Patentblatt 86/20**

(45) Bekanntmachung des Hinweises auf die Patenterteilung:
**01.06.88 Patentblatt 88/22**

(84) Benannte Vertragsstaaten:
**AT BE CH DE FR GB IT LI LU NL SE**

(56) Entgegenhaltungen:
**WO - A - 83/03266**
**DE - A - 3 331 212**
**GB - A - 1 368 318**
**GB - A - 1 567 235**
**GB - A - 2 134 136**
**US - A - 3 859 182**
**US - A - 3 926 749**
**US - A - 4 373 259**
**US - A - 4 440 608**
**US - A - 4 459 185**

**PATENT ABSTRACTS OF JAPAN, unexamined applications, C Field, Vol. 8, No. 122, 8. Juni 1984 THE PATENT OFFICE JAPANESE GOVERNMENT Seite 109 C 227, JP 59-35 694**

(73) Patentinhaber: **Dr.Ing. Max Schlötter GmbH & Co. KG, Talgraben 30, D-7340 Geislingen/Steige (DE)**

(72) Erfinder: **Strube, Gernot, Dr., Karlstrasse 31, D-7340 Geislingen (DE)**
Erfinder: **Jordan, Manfred, Dr., Ringstrasse 23, D-7335 Salach (DE)**

(74) Vertreter: **Eitle, Werner, Dipl.-Ing. et al, Hoffmann, Eitle & Partner Patentanwälte Arabellastrasse 4, D-8000 München 81 (DE)**

## Beschreibung

Die Erfindung betrifft ein Verfahren zur Erhaltung der Lötbarkeit von Bleizinn-Überzügen auf Kupfer- oder Kupferlegierungs-Oberflächen über lange Lagerzeiten, insbesondere auf durchkontaktierten Leiterplatten sowie diese Leiterplatten. Die Erhaltung der Lötbarkeit wird dadurch erreicht, dass vor der Abscheidung eines Bleizinn-Überzuges eine Schicht von reinem Blei auf die Kupfer- oder Kupferlegierungs-Oberfläche aufgebracht wird. Prinzipiell können für die Abscheidung des Blei- und Bleizinn-Überzuges alle Verfahren eingesetzt werden, die eine Abscheidung ohne gegenseitige Beeinflussung der Schichten erlauben. Insbesondere ist jedoch hierfür die elektrolytische Abscheidung geeignet.

Die vorliegende Erfindung soll am Beispiel der Leiterplatten-Herstellung nach dem Metallresist-Verfahren beschrieben werden.

Durchkontaktierte Leiterplatten, die als Endoberfläche einen Bleizinn-Überzug tragen, werden in der Metallresist-Technik nach folgendem Verfahrensprinzip hergestellt:

1. Bohren des doppelseitig mit Kupferfolie kaschierten Basismaterials.
2. Chemische Kupferabscheidung in der Bohrung und auf der Kupferkaschierung.
3. Elektrolytische Verstärkung des nach 2. chemisch abgeschiedenen Kupfer-Überzugs, sofern dieser für eine Weiterverarbeitung nicht ausreichend dick ist.
4. Herstellen einer Negativ-Maske mit Hilfe von Siebdruck oder Photoresist (Galvano-Resist).
5. Aufbau des Leiterbildes durch elektrolytische Kupferabscheidung an den nicht mit Galvano-Resist versehenen Stellen.
6. Elektrolytische Abscheidung von Bleizinn.
7. Strippen des Galvano-Resistes.
8. Ätzen des Kupfers.
9. Umschmelzen des Bleizinn-Überzugs.

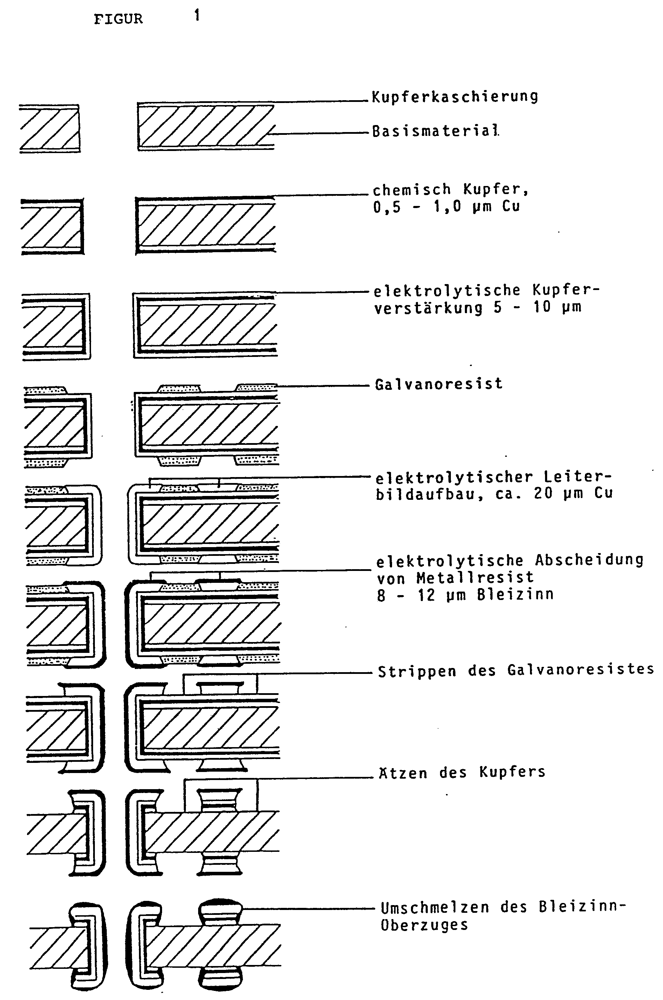

Die Verfahrensfolge wird schematisch durch Abbildung 1 wiedergegeben.

Die aufgeführten Verfahrensschritte stellen prinzipielle Abläufe dar, die zum Teil aus mehreren Einzelschritten bestehen. Eine genaue Beschreibung des Metallresist-Verfahrens findet man im «Handbuch der Leiterplatten-Technik» von Günther Hermann, Eugen G. Leuze Verlag, D-7968 Saulgau/Württemberg, 1982, Seite 191.

Der Verfahrensschritt 3 ist nur dann erforderlich, wenn die Schichtdicke des chemisch abgeschiedenen Kupfer-Überzuges weniger als 2,5 µm beträgt.

Die elektrolytische Abscheidung von Bleizinn erfüllt verschiedene Aufgaben. Zunächst dient das Bleizinn als Schutz über dem elektrolytisch aufgebrachten Kupfer-Leitbild gegen den Angriff der Ätzlösung (Prozess 8.). Da die Bleizinn-Legierung bei der üblicherweise aufgebrachten Zusammensetzung von ca. 30–40% Blei und 70–60% Zinn einen sehr niedrigen Schmelzpunkt hat (ca. 183–195°C), lässt sie sich leicht aufschmelzen, ohne dass das Laminat geschädigt wird. Durch das Aufschmelzen (auch Umschmelzen genannt) läuft das flüssige Bleizinn über die Flanken des Leiterbildes und bedeckt somit die Kupferoberfläche vollständig. Hierdurch erhält man einen sehr guten Korrosionsschutz. Ausserdem ist Bleizinn ein Überzug, der sich hervorragend löten lässt.

Leider hat der Umschmelzprozess einen entscheidenden Nachteil. Während einerseits die Flanken des Leiterbildes sehr gut vom Bleizinn bedeckt werden, ist andererseits die Bleizinn-Verteilung in der Hülse nach der Umschmelzung nicht gleichmässig.

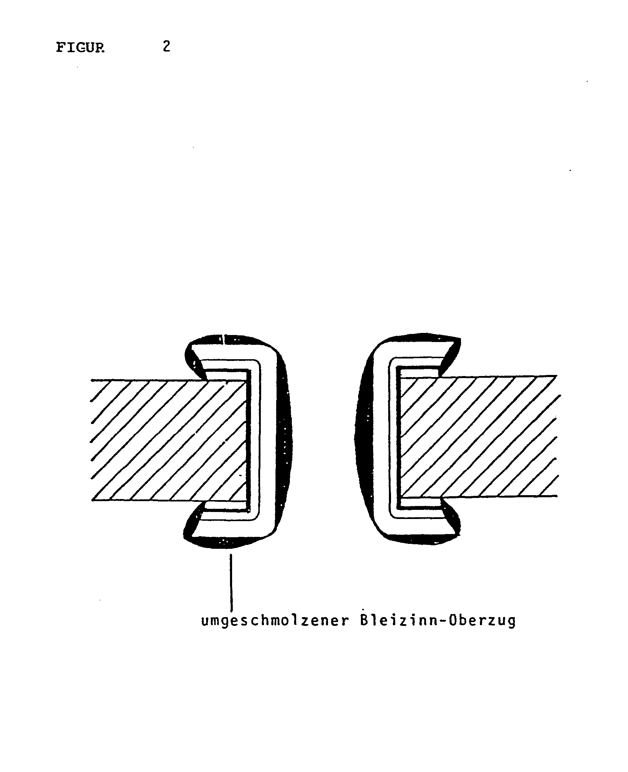

Die Bleizinn-Verteilung in der Hülse veranschaulicht Abbildung 2.

Während vor dem Umschmelzprozess die Schichtdicke des Bleizinn-Überzugs im Kantenbereich der Hülse etwa ebenso stark ist wie auf der Leiterbahn-Oberfläche, findet man nach dem Aufschmelzen im Kantenbereich je nach Arbeitsbedingungen (Aufschmelzen in heissem Öl, Aufschmelzen in Infrarot-Anlagen, Fluxmittel-Verhältnisse) nur noch 0,1 bis ca. 1 µm Bleizinn. Die Endstärke von 0,1 bis ca. 1 µm im Kantenbereich der Hülse ist unabhängig von der ursprünglich aufgebrachten Überzugsstärke (üblicherweise 8–12 µm Bleizinn).

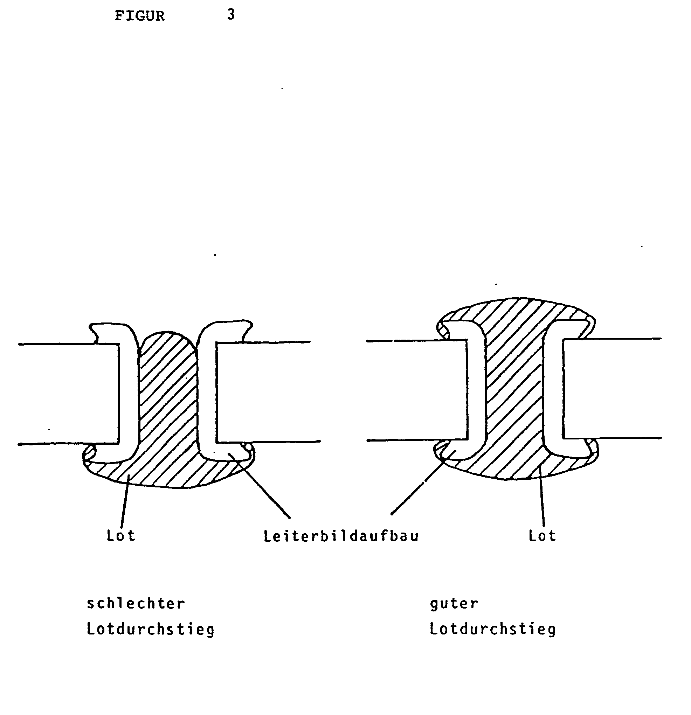

Der sehr dünne Bleizinn-Überzug im Kantenbereich reicht jedoch aus, um eine optimale Lötbarkeit zu gewähren. Dies jedoch nur dann, wenn die Leiterplatte innerhalb weniger Tage mit Bauelementen bestückt und gelötet wird. Nach langer Lagerung der Leiterplatte oder entsprechender Temperung der Leiterplatte, was eine lange Lagerung simulieren soll, entspricht die Lötbarkeit nicht mehr den Anforderungen. Das Lot steigt in der Hülse nicht mehr vollständig durch. Ausserdem bildet sich nach dem Erkalten des Lotes eine konvexe Oberfläche, ein typisches Beispiel dafür, dass die Phasengrenze Kupfer/Lot nicht mehr benetzbar ist. Abbildung 3 demonstriert den Lotdurchstieg bei schlechtere und guter Benetzung.

Die Ursache für die schlechte Benetzbarkeit der Kupferoberfläche ist auf die Bildung der Legierung $Cu_3Sn$ zurückzuführen. Beim Lagern bzw. Tempern der Leiterplatten diffundiert Zinn aus dem Bleizinn-Überzug in die Kupferoberfläche. Da im Kantenbereich nur ein sehr dünner Überzug vorliegt, ist der Vorrat an Zinn verhältnismässig gering. Bei langer Lagerung bzw. entsprechender Temperung bildet sich daher nicht die zinnreiche und gut benetzbare Phase $Cu_5Sn_6$, sondern die zinnarme und nicht benetzbare Phase $Cu_3Sn$.

Überraschenderweise hat sich nun gezeigt, dass mangelhafte Benetzbarkeit dann nicht mehr gefunden wird, wenn als Ätzresist vor der Bleizinn-Abscheidung ein dünner Überzug von Blei abgeschieden und dementsprechend folgender Verfahrensablauf eingehalten wird:

1. Bohren des doppelseitig mit Kupferfolie kaschierten Basismaterials.

2. Chemische Kupferabscheidung in der Bohrung und auf der Kupferkaschierung.

3. Elektrolytische Verstärkung des nach 2. chemisch abgeschiedenen Kupfer-Überzugs, sofern dieser für eine Weiterverarbeitung nicht ausreichend dick ist.

4. Herstellen einer Negativmaske mit Hilfe von Siebdruck oder Photoresist.

5. Aufbau des Leiterbildes durch elektrolytische Kupferabscheidung an den nicht mit Galvano-Resist versehenen Stellen.

6. Elektrolytische Abscheidung von Blei.

7. Elektrolytische Abscheidung von Bleizinn.

8. Strippen des Galvano-Resistes.

9. Ätzen von Kupfer.

10. Umschmelzen des Blei- und Bleizinn-Überzugs.

Die Schichtdicken der Blei- und Bleizinn-Überzüge können in einem grossen Bereich variiert werden, ohne dass sich die Ergebnisse beim Löten deutlich unterscheiden. Mit einer Schichtkombination von 1–5 μm Blei und 8–12 μm Bleizinn erhält man ausgezeichnete Lötergebnisse. Höhere Auflagen sind nicht notwendig.

Die Art der verwendeten Badtypen ist für das Lötergebnis unerheblich, sofern es die Elektrolyte gestatten gleichmässige, feinkristalline Überzüge abzuscheiden und das Bleibad in seinem Grundaufbau dem Bleizinnbad entspricht. So kann man z.B. ein Bleibad und Bleizinnbad verwenden, wenn beide Elektrolyte Tetrafluoroborwasserstoffsäure und die entsprechenden Salze enthalten, einschliesslich der notwendigen Kornverfeinerer. Die Kombination verschiedener Badtypen führte zwar bei der Lötprüfung zu brauchbaren Ergebnissen, jedoch bildete sich nach dem Umschmelzen eine griessartige Oberfläche, die evtl. bei der automatischen Bestückung der Leiterplatte mit Bauteilen zu Problemen führen könnte.

Obwohl die Gründe für die Verbesserung der Lötbarkeit nach der Erfindung noch nicht vollständig geklärt sind, kann man davon ausgehen, dass die Diffusion des Zinns in die Kupfer-Oberfläche gebremst wird. Beim Umschmelzprozess wird die Bleischicht in den Bleizinn-Überzug einlegiert, und es bildet sich offensichtlich eine bleireiche Phase in der der Kupferoberfläche nahen Zone. Diese bleireiche Zone verlangsamt die Zinn-Diffusion bei anschliessender Lagerung bei Raumtemperatur bzw. beim beschleunigten Alterungstest (Temperung bei 150°C).

Weiterhin zeigte sich, dass bei Anwendung der Verfahrensfolge gemäss der Erfindung die Schichtdicke des Bleizinn-Überzugs nach dem Umschmelzprozess im Kantenbereich deutlich stärker ausgeprägt ist als bei einer Verfahrensfolge ohne Blei-Zwischenschicht. Eine Erklärung für dieses Phänomen konnte bisher nicht gefunden werden.

Die folgenden zwei Beispiele sollen die überraschende Wirkung der Zwischenschicht Blei demonstrieren.

Beispiel 1

Aus einer doppelseitig kupferkaschierten Epoxidharzplatte (FR4-Material) wird eine Leiterplatte nach folgendem Verfahrensablauf hergestellt:

1. Bohren

2. Chemische Kupferabscheidung Dynaplate-Verfahren, 0,5 μm Kupfer

3. Elektrolytische Verstärkung Glanzkupferbad Slotocoup, 5 μm Kupfer

4. Herstellen der Negativmaske Beschichten mit alkalilöslicher Photoresistfolie, Belichten, Entwickeln

5. Elektrolytische Abscheidung von Kupfer Glanzkupferbad Slotocoup, 25 μm Kupfer

6. Elektrolytische Abscheidung von Blei Bleibad MSN, 5 μm Blei

7. Elektrolytische Abscheidung von Bleizinn Bleizinnbad Slotelet K, 9 μm Bleizinn (30% Pb/ 70% Sn)

8. Strippen der Negativmaske Wässrige Kaliumhydroxid-Lösung bei 80°C

9. Ätzen ammoniakalische Ammoniumchlorid/ Natriumchlorit-Lösung

10. Umschmelzen des Blei- und Bleizinn-Überzuges Ölbad auf Basis Polyglykol, T = 210–215°C, t = 10 sec.

11. Tempern 155°C – 16 h

12. Löten Übliche Anlage zum Schwallöten. Vorschub: 1,2 m/min; Fluxmittel: 25% Kollophonium in iso-Propanol; Lötbadtemperatur: 240°C

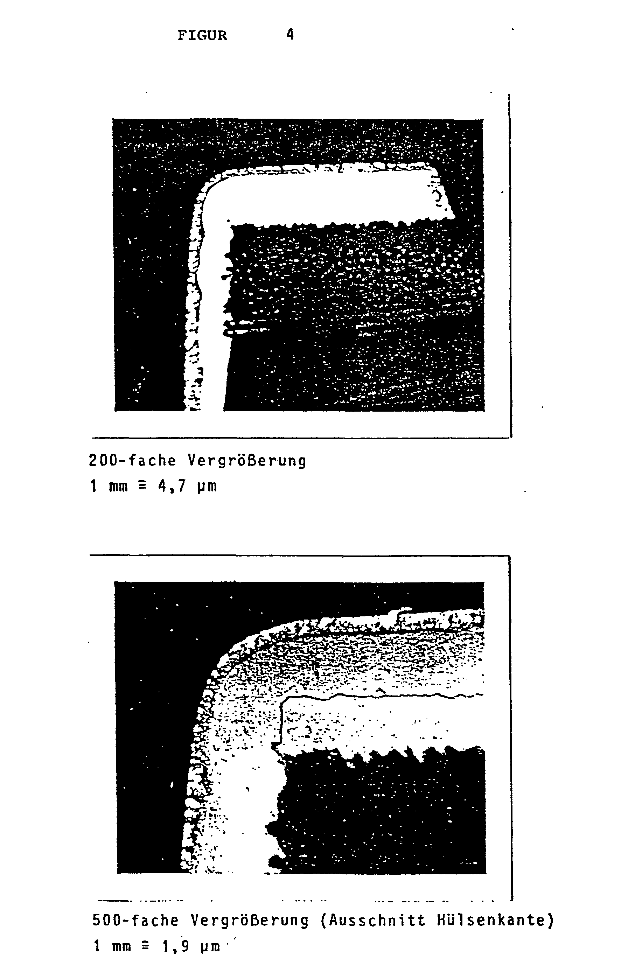

Die gelötete Leiterplatte zeigte optimalen Lotdurchstieg. Nach Schritt 10 wurde von einer Probe ein Querschliff angefertigt. Die Aufnahme wird durch Abbildung 4 wiedergegeben. Im Kantenbereich sind ca. 7 μm Bleizinn-Überzug zu erkennen.

Beispiel 2

Eine Leiterplatte wird wie in Beispiel 1 angegeben hergestellt, jedoch wird Verfahrensschritt 6 ausgelassen.

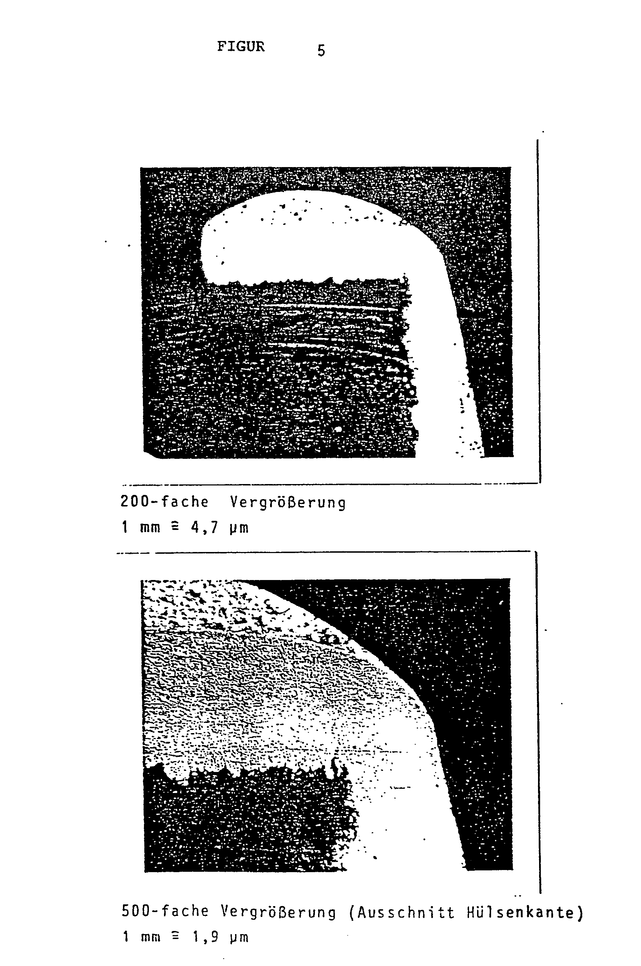

Die Leiterplatte zeigte etwa bei 20% der Hülsen einen unvollständigen Lotdurchstieg mit einer konvexen Oberfläche. Die Aufnahme einer Hülse im Querschliff nach dem Umschmelzprozess zeigt Abbildung 5.

Eine Erprobung des erfindungsgemässen Verfahrens unter praxisnahen Bedingungen hat gezeigt, dass bei allen gefertigten Leiterplatten der Lotdurchstieg optimal erfolgte.

**Patentansprüche**

1. Verfahren zur Herstellung von durchkontaktierten Leiterplatten nach der Metall-Resist-Technik unter Verwendung von Blei-Zinn als Metallresist und anschliessende Umschmelzung des Blei-Zinn-Überzuges, wobei der Metallresist auf der Oberfläche vorliegt, dadurch gekennzeichnet, dass vor der Abscheidung von Blei-Zinn eine Zwischenschicht von Blei elektrolytisch abgeschieden wird.

2. Verfahren nach Anspruch 1, dadurch gekennzeichnet, dass der Blei-Überzug eine Schichtdicke von 0,1 bis 10 µm und der Blei-Zinn-Überzug eine Schichtdicke von 0,1 bis 50 µm hat.

3. Verfahren nach Anspruch 1, dadurch gekennzeichnet, dass der Blei-Überzug eine Schichtdicke von 1 bis 5 µm und der Blei-Zinn-Überzug eine Schichtdicke von 8 bis 12 µm hat.

4. Durchkontaktierte Leiterplatte, enthaltend auf Kunststoffmaterial eine doppelseitige Schicht aus Kupfer in Form des Leiterbildes und hierauf aufgebracht eine Schicht von 0,1 bis 50 µm Bleizinn, dadurch gekennzeichnet, dass zwischen dem Kupferleiterbild und dessen Blei-zinn-Überzug eine Blei-Zwischenschicht vorgesehen ist.

5. Durchkontaktierte Leiterplatte nach Anspruch 4, dadurch gekennzeichnet, dass die Blei-Zwischenschicht eine Stärke von 0,1 bis 10 µm aufweist.

## Claims

1. Method for manufacture of through-contacted conductor plates according to the metal resist technology with the use of lead-tin as metal resist and subsequent remelting of the lead-tin coating, the metal resist being present on the surface, characterised in that before the deposition of lead-tin an intermediate layer of lead is electrolytically deposited.

2. Method according to claim 1, characterised in that the lead coating has a layer thickness of 0.1 to 10 µm and the lead-tin coating has a layer thickness of 0.1 to 50 µm.

3. Method according to claim 1, characterised in that the lead coating has a layer thickness of 1 to 5 µm and the lead-tin coating a layer thickness of 8 to 12 µm.

4. Through-contacted conductor plate, containing on synthetic material a copper layer on both sides in the form of the conductor image and a layer of 0.1 to 50 µm lead-tin applied to it, characterised in that between the copper conductor image and its lead-tin coating a lead intermediate layer is provided.

5. Through-contacted conductor plate according to claim 4, characterised in that the lead intermediate layer has a thickness of 0.1 to 10 µm.

## Revendications

1. Procédé de fabrication de cartes de circuits imprimés à trous métallisés d'après la technique de l'épargne métallique, avec utilisation de plomb-étain comme métal d'épargne et refusion subséquente du revêtement plomb-étain, le métal d'épargne se trouvant à la surface, caractérisé en ce qu'une couche intermédiaire de plomb est déposée par électrolyse avant le dépôt de plomb-étain.

2. Procédé selon la revendication 1, caractérisé en ce que le revêtement de plomb présente une épaisseur de couche de 0,1 à 10 µm et le revêtement de plomb-étain une épaisseur de couche de 0,1 à 50 µm.

3. Procédé selon la revendication 1, caractérisé en ce que le revêtement de plomb présente une épaisseur de couche de 1 à 5 µm et le revêtement de plomb-étain une épaisseur de couche de 8 à 12 µm.

4. Carte de circuits imprimés à trous métallisés, comportant une couche de cuivre sous la forme du dessin conducteur sur les deux faces d'un substrat de matière plastique et une couche de 0,1 à 50 µm de plomb-étain déposée sur celui-ci, caractérisée en ce qu'il est prévu une couche intermédiaire en plomb entre le dessin conducteur en cuivre et son revêtement de plomb-étain.

5. Carte de circuits imprimés à trous métallisés selon la revendication 4, caractérisée en ce que la couche intermédiaire de plomb présente une épaisseur de 0,1 à 10 µm.

FIGUR    1

Kupferkaschierung

Basismaterial

chemisch Kupfer,
0,5 - 1,0 µm Cu

elektrolytische Kupfer-
verstärkung 5 - 10 µm

Galvanoresist

elektrolytischer Leiterbildaufbau, ca. 20 µm Cu

elektrolytische Abscheidung
von Metallresist
8 - 12 µm Bleizinn

Strippen des Galvanoresistes

Ätzen des Kupfers

Umschmelzen des Bleizinn-
Oberzuges

FIGUR        2

umgeschmolzener Bleizinn-Oberzug

FIGUR          3

Lot          Leiterbildaufbau          Lot

schlechter                    guter
Lotdurchstieg                 Lotdurchstieg

FIGUR 4

200-fache Vergrößerung
1 mm ≙ 4,7 µm

500-fache Vergrößerung (Ausschnitt Hülsenkante)
1 mm ≙ 1,9 µm

FIGUR      5

200-fache   Vergrößerung
1 mm ≅ 4,7 µm

500-fache Vergrößerung (Ausschnitt Hülsenkante)
1 mm ≅ 1,9 µm